# EUROPEAN PATENT APPLICATION

(11) **EP 4 765 639 A1**
(43) Date of publication of application: **24.06.2026**
(21) Application number: 25214760.8
(22) Date of filing: 10.11.2025
(51) Int. Cl.: H03K 17/042

(54) **A METHOD AND CIRCUIT ARRANGEMENT FOR SWITCH BOOST CURRENT**

(30) Priority: 18.12.2024 US 202418985567
(71) Applicant: Analog Devices International Unlimited Company, Co. Limerick (IE)
(72) Inventor: Aherne, David, Limerick (IE)
(74) Representative: Horler, Philip John

(57) **Abstract**

A method and circuit arrangement for a solid state switch device is disclosed. In certain embodiment, a solid state switch device comprising a controllable switch comprising a control terminal, a first channel terminal, and a second channel terminal, and arranged to be switched between an off-state and an on-state, wherein in the on-state the switch allows a current to flow between the first channel terminal and the second channel terminal. The solid state switch device further comprising: a first compensation circuit configured to: generate a first boost current based on a voltage difference between the first channel terminal and the second channel terminal; and apply the first boost current to the control terminal to charge a switch capacitance of the controllable switch.

## Description

### FIELD

This application relates to compensating for capacitance in a semiconductor switch (i.e. a solid state switch). Specifically, during turn-on of the semiconductor switch when there is a voltage differential across the terminals of the semiconductor switch.

### BACKGROUND

Solid state switches may be used with components such as, a precision measurement apparatus, and high voltage automated test equipment. A solid state switch can have an associated capacitance associated with a control terminal which affects the turn-on time of a solid state switch. A longer turn-on time may negatively affect the precision of measurements made via the solid state switch. For example, a large capacitance solid state switch may limit the speed that the solid state switch can turn-on and turn-off, and may increase the time required to achieve an accurate component measurement.

### SUMMARY OF THE DISCLOSURE

Embodiments of the present disclosure provide solid state switches with an improved turn-on time. Such solid state switches are suitable for use with precision measurement apparatuses and high voltage automated test equipment.

According to a first aspect there is provided a solid state switch device, comprising:
a controllable switch comprising a control terminal, a first channel terminal, and a second channel terminal, and arranged to be switched between an off-state and an on-state, wherein in the on-state the switch allows a current to flow between the first channel terminal and the second channel terminal; and
a first compensation circuit configured to:
   generate a first boost current based on a voltage difference between the first channel terminal and the second channel terminal; and
   apply the first boost current to the control terminal to charge a switch capacitance of the controllable switch.

Advantageously, the first boost current is dynamic and improves turn on time, and avoids providing excessive current which can damage and violate the max Vgs of the controllable switch (e.g., when there is a large voltage differential across the solid state switch).

The first compensation circuit may be configured to apply the first boost current to the control terminal of the controllable switch during a transition of the controllable switch from the off-state to the on-state. The first compensation circuit may be configured to apply the first boost current to the control terminal of the controllable switch during a transition of the controllable switch from the off-state to a low-resistance on-state of the controllable switch.

The on-state may comprise a first on-state defined by the channel resistance between the first and second channel terminals of the controllable switch being greater than a predetermined first resistance threshold. The first on-state may be a high-resistance on-state. The on-state may comprise a second on-state defined by the channel resistance between the first and second channel terminals of the controllable switch being less than a predetermined second resistance. The second on-state may be a low-resistance on-state. The predetermined first resistance threshold may be the second resistance threshold. The predetermined first resistance may be greater than the predetermined second resistance threshold. The first boost current may be applied during a transition of the controllable switch from the off-state to the second on-state.

The first compensation circuit may be configured to apply the first boost current until the voltage difference between the first channel terminal and the second channel terminal reduces to or below a difference threshold voltage (e.g. substantially zero).

The on-state may comprise a first on-state defined by the control voltage of the controllable switch being greater than a predetermined voltage threshold (*Vₜ*) of the controllable switch. The first on-state may be a high-resistance on-state. The on-state may comprise a second on-state defined by the control voltage of the controllable switch being greater than a target threshold voltage level. The second on-state may be a low-resistance on-state. The target threshold voltage level may be greater than the predetermined voltage threshold (*Vₜ*).

The first compensation circuit may be configured to, during the application of the first boost current, adjust the first boost current proportionally with any changes to the voltage difference between the first channel terminal and the second channel terminal.

During application of the first boost current, the first boost current may be of fixed amplitude. The first compensation circuit may be configured to apply the first boost current for a time period; and/or determine the fixed amplitude and time period based on the voltage difference between the first channel terminal and the second channel terminal at a time prior to application of the first boost current.

The solid state switch device may further comprise an control switch arranged to couple the first compensation circuit to the control terminal. The control switch may be configured to selectively apply the first boost current during a transition of the controllable switch from the off-state to the on-state. The solid state switch device may further comprise an control switch arranged to couple the first compensation circuit to the control terminal. The control switch may be configured to selectively apply the first boost current during a transition of the controllable switch from the off-state to a low-resistance on-state of the controllable switch.

The solid state switch device may further comprise a second compensation circuit. The second compensation circuit may be configured to: generate a second boost current of predetermined fixed amplitude; and/or apply the second boost current to the control terminal to charge a switch capacitance of the controllable switch during a transition of the controllable switch from the off-state to the on-state or a low-resistance on-state of the controllable switch.

The second boost current to the control terminal to charge a switch capacitance of the controllable switch is applied during a period of time (e.g., from the on-state, specifically, from high-resistance on-state, and) after the voltage difference between the first channel terminal and the second channel terminal is less than or equal to a difference threshold voltage (e.g. equalised).

The second boost current may be applied during the application of the first boost current.

The fixed amplitude of the second boost current may be less than the peak amplitude of the first boost current.

The solid state switch device may be configured to: monitor a control voltage (Vgs) at the control terminal with respect to a reference voltage; and stop applying the second boost current in response to determining that the control voltage (Vgs) reaches a control threshold voltage. Alternatively, the solid state switch device may stop applying the second boost current based on the target threshold voltage and the known capacitance of the switch capacitance.

The first compensation circuit may further comprise a first buffer, a second buffer, and a resistive element. The first buffer may be configured to detect a first voltage at the first channel terminal and apply a first buffer voltage to a first terminal of the resistive element. The first buffer voltage may be proportional to the first voltage. The second buffer may be configured to detect a second voltage at the second channel terminal and apply a second buffer voltage a second terminal of the resistive element. The second buffer voltage may be proportional to the second voltage.

The first compensation circuit may comprise a first current mirror arrangement configured to generate the first boost current based on the current flowing through the resistive element.

The solid state switch device may be a bi-directional solid state switch. The first current mirror arrangement may be configured to generate the first boost current if a voltage at the first channel terminal is greater than the voltage at the second channel terminal. The first compensation circuit may further comprise a second current mirror arrangement configured to generate the first boost current if a voltage at the second channel terminal is greater than the voltage at the first channel terminal.

The first compensation circuit may be configured to detect a first voltage at the first channel terminal with respect to a voltage reference. The first compensation circuit may be configured to detect a second voltage at the second channel terminal with respect to the voltage reference. The first compensation circuit may be configured to generate the first boost current based on the first and second voltage.

The controllable switch may comprise a first Field Effect Transistor, FET. The control terminal may comprise a gate terminal of the first FET. The first channel terminal may comprise a drain terminal of the first FET.

The switch capacitance of the controllable switch may be a parasitic gate-source capacitor (Cgs) of the first FET.

The controllable switch may further comprise a second FET. A source terminal of the first FET may be coupled to a source terminal of the second FET. The control terminal of the controllable switch may further comprise a gate terminal of the second FET. The second channel terminal may comprise a drain terminal of the second FET.

The first and/or second buffer may be a unity gain buffer (UGB), a voltage follower, or a cascade complementary source follower.

The controllable switch may be a FET, MOSFET, DMOS, or a Lateral Double-Diffusion MOSFET (LDMOS).

According to a second aspect there is provided a method for charging a switch capacitance at a control terminal of a controllable switch, the method comprising:
determining a voltage difference between a first channel terminal of a controllable switch and a second channel terminal of the controllable switch;
generating a first boost current based on to the voltage difference; and
applying the first boost current to the control terminal to charge a switch capacitance of the controllable switch.

The first boost current may be applied during a transition of the controllable switch from the off-state to the on-state. The first boost current may be applied during a transition of the controllable switch from the off-state to a low-resistance on-state of the controllable switch.

The method may further comprise generating a second boost current of fixed amplitude. The method may further comprise applying the second boost current to the control terminal to charge a switch capacitance of the controllable switch when the voltage difference between the first channel terminal and the second channel terminal is less than or equal to a difference threshold voltage.

According to a third aspect there is provided a compensation circuit configured to be coupled to: a control terminal of a controllable switch; a first channel terminal of the controllable switch; and a second channel terminal of the controllable switch, wherein the compensation circuit is further configured to:
generate a first boost current based on a received voltage difference between the first channel terminal of the controllable switch and the second channel terminal of the controllable switch; and
output the first boost current for receipt by the control terminal of the controllable switch.

Optional features of the first aspect may be applied to the second aspect and/or the third aspect.

### BRIEF DESCRIPTION OF THE DRAWINGS

Figure 1 illustrates a design of an NLDMOS switch with the parasitic drain-substrate capacitor (*C_{dsub}*), a parasitic source-drain capacitor (*C_{sd}*), a parasitic gate-source capacitor (*C_{gs}*), and a parasitic gate-drain capacitor (*C_{gd}*).
Figure 2 illustrates a schematic block wiring diagram of a solid state switch comprising a controllable switch and a compensation circuit.
Figure 3 illustrates multiple graphs over a time period during the switch-on of a controllable switch as the control terminal capacitance charges.
Figure 4 illustrates a schematic block wiring diagram of a solid state switch comprising a controllable switch, a first compensation circuit, and a second compensation circuit, with optional features.
Figure 5 illustrates a practical example of the solid state switch of Figure 7.
Figure 6 illustrates a schematic block wiring diagram of a compensation circuit, with optional features.
Figure 7 illustrates a process to charge a switch capacitance of a controllable switch.
Figure 8 illustrates a schematic block wiring diagram of a solid state switch comprising a controllable switch, a first compensation circuit, and a second compensation circuit, with optional features.
Figure 9 illustrates a schematic block wiring diagram of a compensation circuit, with optional features.
Figure 10 illustrates a schematic Vgs detect circuit which receives the gate voltage and source voltage of the controllable switch.
Figure 11a illustrates a schematic block wiring diagram of a compensation circuit, with optional features.
Figure 11b illustrates a schematic block wiring diagram of a compensation circuit, with optional features.

### DETAILED DESCRIPTION OF EMBODIMENTS

A controllable switch, such as a Field Effect Transistor, FET, when configured to function as a switch is susceptible to parasitic capacitance which can negatively impact performance of the controllable switch. To overcome the impact of parasitic capacitance, additional circuitry can be coupled to the controllable switch. Many types of controllable switches such as many types of FETs (e.g., GaN FETs, JFETs, Metal Oxide Silicon FETs (MOSFETs or called MOSs), Diffusion MOSs (DMOSs), Lateral DMOSs (LDMOSs), vertical DMOSs (VDMOSs), etc.) can benefit from the additional circuitry. For example, the controllable switches described below may be LDMOS devices configured to function as switches. In addition, the LDMOS devices may be lateral doubly diffused MOS devices. A DMOS device may imply a high-voltage device. For example, greater than 5V, or, greater than/equal to 10V, can be high-voltage.

If the voltage differential across the controllable switch in an off-state is small, then a small boost current will be needed to charge the parasitic capacitance. If the voltage differential across the controllable switch in an off-state is large, then a large boost current will be needed to charge the parasitic capacitance. It is desirable to adapt the boost current to the voltage across the controllable switch. Without this adaptation, the circuit will typically be designed to generate a boost current across the controllable switch to charge the worst-case parasitic capacitance. This may result in excessive current being applied to the parasitic capacitance if only a small voltage difference is present over the controllable switch. This excessive current will need to be clamped to prevent violation of max control voltage and damage to the controllable switch.

As a brief non-limiting overview of an embodiment of the invention, a new solid state switch device for use in/with high voltage precision instruments is provided. The new solid state switch device can enable fast charging of parasitic capacitances associated with control terminals of a controllable switch with a boost current, to enable turn-on of a controllable switch in a short time. The new solid state switch device can comprise a controllable switch and a compensation circuit configured to generate the boost current based on the voltage across the controllable switch.

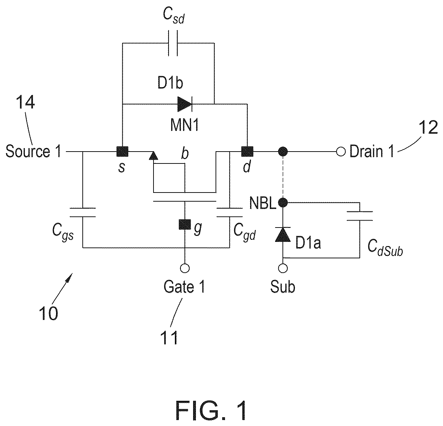

Figure 1 shows an example of a controllable switch 10. The controllable switch comprises first and second channel terminals 12, 14. Specifically, an n-type LDMOS 10 (i.e., NLDMOS 10) is shown. NLDMOS 10 comprises a gate terminal (Gate1) 11, a drain terminal (Drain1) 12, and a source terminal (Source1) 14. The parasitic diode D1a is formed between the substrate and the isolation layer, such as an NBL in Figure 1. The NBL is coupled to a NBL terminal, which may be accessible to a circuit designer. The NBL terminal may typically be shorted to the drain terminal 12 for normal operation, which may reduce noise from the substrate. This may be achieved by externally coupling the NBL terminal to the drain terminal 12 or may be achieved by an internal connection of the NBL to the drain. The parasitic diode D1b is formed between the source and drain of the NLDMOS 10. The parasitic diodes D1a and D1b are formed between P-type and N-type material of the NLDMOS 10.

The parasitic diodes D1a and D1b of the NLDMOS 10 result from the fabrication process and are present in many types of DMOS switches. The parasitic diode D1a (between the substrate Sub and an isolation layer, e.g. an N-type buried layer (NBL)) of the NLDMOS 10 may also be present in other controllable switches.

The NLDMOS 10 comprises a parasitic drain-substrate capacitor (*C_{dsub}*), *a* parasitic source-drain capacitor (*C_{sd}*), a parasitic gate-source capacitor (*C_{gs}*), and a parasitic gate-drain capacitor (*C_{gd}*)*.* The parasitic components shown in Figure 1 are the dominant parasitic components when the NLDMOS 10 is switched to an off-state and the voltage at the drain 12 is greater than the voltage at the source 14.

LDMOS devices are suitable for use in high voltage applications and may have source and channel regions formed using a double diffusion process. As a result of the fabrication process, the NLDMOS 10 is a uni-directional solid state switch and the parasitic diodes D1a and D1b are formed between high voltage P-type and N-type material. For example, when gate terminal 11 of the (uni-directional) NLDMOS switch 10 receives an 'OFF' signal, current may still flow from source terminal 14 to drain terminal 12 via the (forward biased) parasitic diode D1b. In an example, a bidirectional controllable switch may be formed from multiple LDMOSs. Specifically, a bi-directional NLDMOS switch may comprise a first NLDMOS and a second NLDMOS in series. The source terminal of the first NLDMOS is coupled to a source terminal of the second NLDMOS, to block current flow in either direction. The source terminal may be biased to the mid-point of the voltage differential across the controllable switch (i.e., between the drain terminals of the first and second NLDMOS). Therefore, the voltage at the source terminals of the first and second NLDMOS (and thus, their gate-source voltage, *V_{gs}*) may be based on the voltage differential across the controllable switch. In alternate examples any such controllable switch may be bi-directional.

To switch NLDMOS 10 to an on-state requires a gate-source voltage, *V_{gs}*, to reach a target threshold voltage level. At the threshold *Vₜ* a channel (i.e., conducting path between the first and second channel terminals 12, 14) is formed within the NLDMOS 10 and is typically understood to be in an on-state, however, this is a high-resistance on-state because the NLDMOS 10 may not be able to pass sufficient current through the channel. As the switch capacitance charges in the on-state, the on-state resistance transitions from a high-resistance to a low-resistance and the gate-source voltage increases during this transition. Once the switch capacitance is fully charged from current applied to a control terminal 11, the switch is in a low-resistance on-state. In addition, the low-resistance on-state may be considered to comprise an on-state which provides sufficient current through the channel (i.e., a sufficiently low resistance) during the transition from a high-resistance on-state to a low-resistance on-state. Therefore, the target threshold voltage level is the voltage level at which the *V_{gs}* enables sufficient current through the channel, for the controllable switch to be in the low-resistance on-state. Thus, the target threshold voltage level is greater than the threshold *Vₜ* of the controllable switch.

For the gate-source voltage, *V_{gs},* to raise to the target threshold voltage level, the switch capacitance of the controllable switch must first be charged. If a control terminal 11 is provided with a switch control signal from a controller which is only able to provide a small, fixed current, then the *V_{gs}* will take a long time to reach the target threshold voltage level as the switch capacitance charges. Specifically, the switch capacitance charges may be parasitic capacitances with a terminal directly electrically coupled to the gate of the controllable switch. Therefore, a compensation circuit is provided to generate and apply a boost current to the controllable switch. Advantageously, the boost current enables the controllable switch to reach the target threshold voltage level (i.e., switch from the off-state to the low-resistance on-state) quickly.

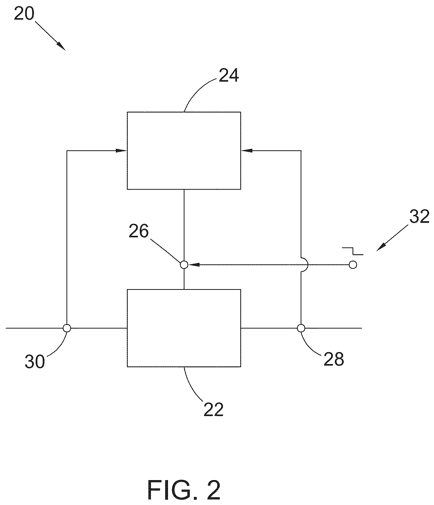

Figure 2 shows a solid state switch device 20, comprising a controllable switch 22 (for example, NLDMOS 10 of Figure 1) and a compensation circuit 24. The controllable switch 22 comprises a control terminal 26, a first channel terminal 28, and a second channel terminal 30. The controllable switch 22 is arranged to be switched between an off-state and an on-state by a switch control signal 32 applied to the control terminal 26. The on-state the controllable switch 20 allows a current to flow between the first channel terminal 28 and the second channel terminal 30. The low-resistance on-state may be defined by the control voltage being greater than the target threshold voltage level, and/or by the current level of the current between the first channel terminal 28 and the second channel terminal 30 being greater than a target threshold current level. The target threshold voltage level may be the voltage level which permits current at the target threshold current level to flow through the controllable switch 22.

The compensation circuit 24 is configured to generate a first boost current based on a voltage difference between the first channel terminal 28 and the second channel terminal 30. The compensation circuit 24 is then configured to apply the first boost current to the control terminal 26 to charge a switch capacitance of the controllable switch 22.

The first boost current which is based on the voltage difference may advantageously dynamically adjust to improve the time for the controllable switch 22 to transition from the off-state to the low-resistance on-state. In addition, the first boost current (being based on the voltage difference) may avoid providing excessive current to the control terminal 26 which may violate the maximum gate-source voltage *V_{gs}* of the controllable switch 22 and damage the controllable switch 22.

In an example, the first boost current may be proportional to the voltage difference between the first channel terminal 28 and the second channel terminal 30. In an alternative example, the first boost current may have a different relationship to the voltage difference between the first channel terminal 28 and the second channel terminal 30, such that a change in the voltage difference causes a change in the first boost current.

The compensation circuit 24 may be configured to apply the first boost current to the control terminal 26 of the controllable switch 22 during a transition of the controllable switch 22 from the off-state to the on-state. The compensation circuit 24 may be deactivated after the controllable switch 22 is in its on-state. The compensation circuit 24 may be deactivated such that it does not output the first boost current to the control terminal 26. Advantageously, this will be the time period (i.e., during a transition of the controllable switch 22 from the off-state to the on-state) when the controllable switch 22 benefits the most from the compensation circuit 24. In addition, deactivating the compensation circuit 24 may prevent the circuit from being sensitive to transient voltages on the first and/or second channel terminals 28, 30 of the controllable switch 22 in the on-state. Thus, avoiding adding a boost current during normal on-state of the controllable switch 22.

The compensation circuit 24 may be configured to apply the first boost current until the voltage difference between the first channel terminal 28 and the second channel terminal 30 reduces to or below a difference threshold voltage. The difference threshold voltage may be 5V, 1V, 0.5V, substantially zero volts, or 0V. In an example, the solid state switch device 20 may be configured to electrically disconnect the compensation circuit 24 from the control terminal 26 of the controllable switch 22 in response to determining that the voltage difference is less than or equal to the difference threshold voltage.

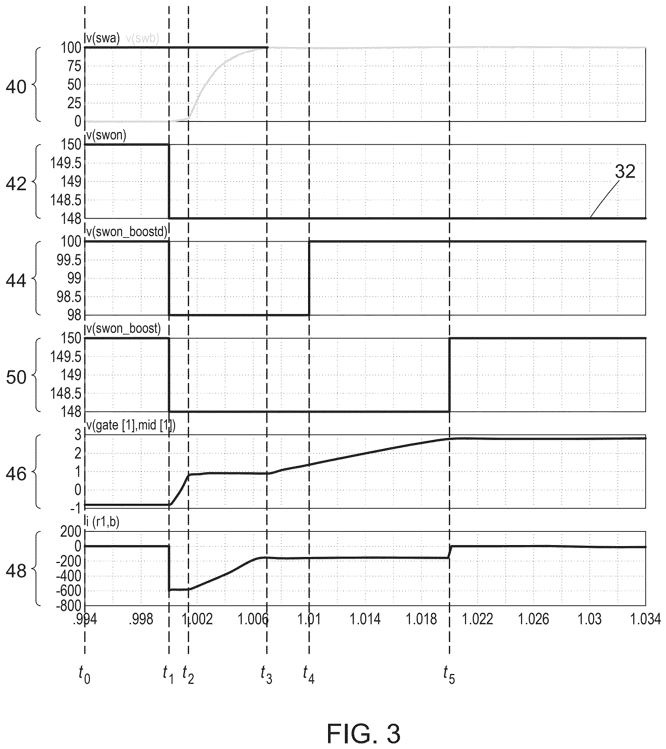

Figure 3 shows six graphs 40, 42, 44, 46, 48, and 50 with a common time scale.

A first graph 40 is a graph showing the voltage difference between the first channel terminal 28 and the second channel terminal 30. At times *t*₀, *t*₁, the voltage on the first channel terminal 28 is shown to be 100V, and the voltage on the second channel terminal 30 is shown to be 0V. At times *t*₃, *t*₄, *t*₅, the voltage on the first and second channel terminals 28, 30 is shown to be 100V. Thus, the voltage difference between the first channel terminal 28 and the second channel terminal 30 reduces from 100V to 0V.

A second graph 42 is a graph showing the switch control signal 32 which is configured to switch the controllable switch 22 from the off-state to the on-state at time *t*₁.

A third graph 44 is a graph showing an activation signal of the compensation circuit 24 which is configured to allow the first boost current to be applied to the control terminal 26 between times *t*₁ and *t*₄.

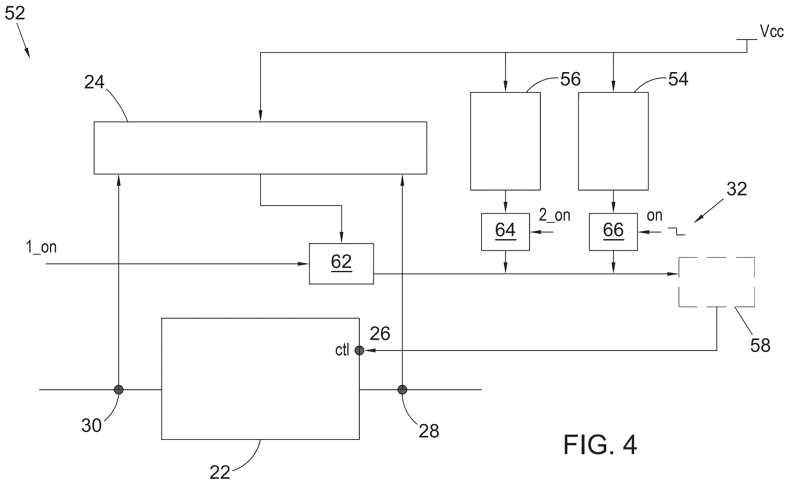

A fourth graph 46 is a graph showing the control voltage (e.g., gate-source voltage *V_{gs}*) raising from an initial voltage level at time *t*₀, *t*₁ to be greater than the target threshold voltage level at time *t*₅. Between times *t*₃ and *t*₅ the control voltage, appears to raise linearly because a constant current is applied to the control terminal 26 of the controllable switch 22. The constant current may be provided by a controller, or by a distinct second compensation circuit configured to generate an optional second boost current of predetermined fixed amplitude (which will be described with reference to Figure 4).

A fifth graph 48 is a graph showing the current profile at the control terminal 26 which charges the switch capacitance of the controllable switch 22. The current profile shows the current being applied to the control terminal 26. At times *t*₀, *t*₁ and *t*₅ no boost current is applied.

Between times *t*₁ and *t*₂ the control voltage raises until the cut-off voltage is reached at time *t*₂. Between times *t*₂ and *t*₃ the voltage difference between the first channel terminal 28 and the second channel terminal 30 reduces (as shown in first graph 40), and the first boost current (represented in the current profile, as shown in the fifth graph 48) dynamically changes. That is, during the application of the first boost current, the first boost current is adjusted proportionally with any changes to the voltage difference between the first channel terminal 28 and the second channel terminal 30. Between times *t*₃ and *t*₄ the first boost current is not applied by the compensation circuit 24 because the voltage difference between the first channel terminal 28 and the second channel terminal 30 is below the difference threshold voltage.

Figure 4 shows a solid state switch device 52. The solid state switch device 52 of Figure 4 shows all of the features of the solid state switch device 20 of Figure 2, in addition to certain optional features. The same reference numerals are used to denote the same/corresponding features in relation to Figure 2 and will not be described in detail again below.

The solid state switch device 52 may comprise a switch current circuit 54 to provide the switch control signal 32 which is configured to switch the controllable switch 22 from the off-state to the on-state.

A sixth graph 50 of Figure 3 is a graph showing an activation signal of the second compensation circuit 56 which is configured to provide the second boost current to the control terminal 26 between times *t*₁ and *t*₅. The solid state switch device 52 may comprise a second compensation circuit 56. The second compensation circuit 56 may be configured to generate a second boost current of predetermined fixed amplitude. The second compensation circuit 56 may also be configured to apply the second boost current to the control terminal 26 to charge the switch capacitance of the controllable switch 22 during the transition of the controllable switch 22 from the off-state to the on-state (e.g., between times *t*₁ and *t*₅ in Figure 3).

The second boost current provides additional compensation to charge the switch capacitance once the first channel terminal 28 and the second channel terminal 30 are at approximately the same voltage (or less than or equal to a difference threshold voltage). Specifically, even after the first channel terminal 28 and the second channel terminal 30 are at approximately the same voltage (e.g., after time *t*₃ in Figure 3), there is still some uncharged switch capacitance remaining which may be calculated based on the target threshold voltage level (i.e., final control voltage), and the size of the switch capacitance.

The second boost current may be applied while the first boost current is applied as shown by the third and sixth graphs 44, 50 of Figure 3. As shown in Figure 3, fifth graph 48, the current profile between times *t*₁ and *t*₂ is 600uA and is provided by the first boost current and the second boost current. Specifically, the second boost current is approximately 200uA and the first boost current is approximately 400uA, between times *t*₁ and *t*₂. Thus, in an example, the fixed amplitude of the second boost current is less than the peak amplitude of the first boost current. In another example, the second boost current may be applied for less time than the first boost current, and the fixed amplitude of the second boost current may be greater than shown in the fifth graph 48 of Figure 3.

Figure 4 also shows an optional resistive component 58 to generate the control voltage based on the current generated by one or more of the first compensation circuit 24, the second compensation circuit 56, and the switch current circuit 54.

The solid state switch device 52 further comprises a first control switch 62 arranged to couple the first compensation circuit 24 to the control terminal 26. The first control switch 62 is configured to selectively apply the first boost current. The first control switch 62 may be configured to apply the first boost current during a transition of the controllable switch 22 from the off-state to the low-resistance on-state. During the low-resistance on-state of the controllable switch 22, during steady-state operation, the first control switch 62 may be configured to not apply the first boost current. Advantageously, the first control switch 62 prevents a first boost current from being applied during the low-resistance on-state of the controllable switch 22. This may prevent a voltage transient at a channel terminal 28, 30 from resulting in the first boost current being applied to the control terminal 26 of the controllable switch 22. The first control switch 26 may comprise a control terminal to receive control signal "1_on" as shown in Figure 4.

The solid state switch device 52 may comprise a second control switch 64 arranged to couple the second compensation circuit 56 to the control terminal 26. The second control switch 64 is configured to selectively apply the second boost current. The second control switch 64 may be configured to apply the second boost current during a transition of the controllable switch 22 from the off-state to the low-resistance on-state. During the low-resistance on-state of the controllable switch 22, during normal operation, the second control switch 64 may be configured to not apply the second boost current. The second control switch 64 may comprise a control terminal to receive control signal "2_on" as shown in Figure 4.

The solid state switch device 52 may comprise a third control switch 66 arranged to couple the switch current circuit 54 to the control terminal 26. The third control switch 66 is configured to selectively apply current associated with the switch control signal 32. The third control switch 66 may comprise a control terminal to receive the switch control signal 32 (e.g, "on" as shown in Figure 4).

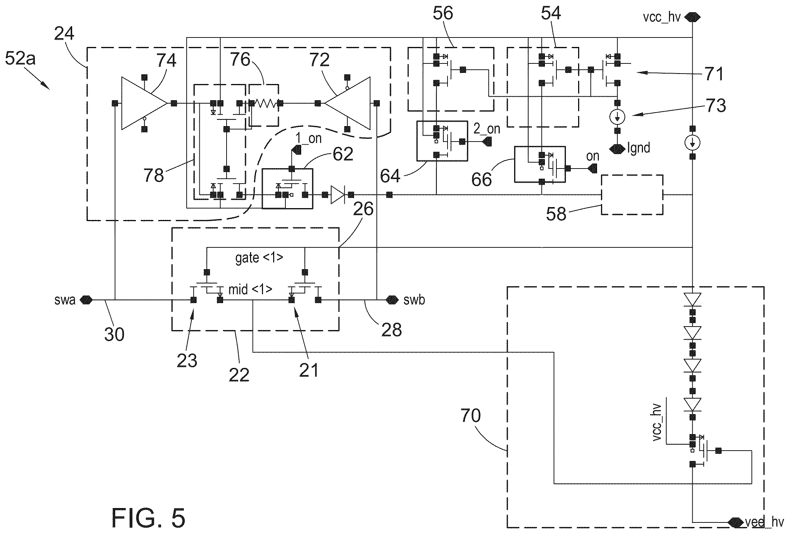

Figure 5 shows a solid state switch device 52a. The solid state switch device 52a of Figure 5 shows all of the features of the solid state switch device 52 of Figure 4, in addition to certain optional features. The same reference numerals are used to denote the same/corresponding features in relation to Figure 4 and will not be described in detail again below.

As shown in Figure 5, the first compensation circuit 24 further comprises a first buffer 72, a second buffer 74, and a resistive element 76, e.g., a resistor.

The first buffer 72 is configured to detect a first voltage at the first channel terminal 28 and apply a first buffer voltage to a first terminal of the resistive element 76. The first buffer voltage may be proportional to the first voltage. The second buffer 74 may be configured to detect a second voltage at the second channel terminal 30 and apply a second buffer voltage to a second terminal of the resistive element 76. The second buffer voltage may be proportional to the second voltage.

In an alternative example, the first compensation circuit 24 may be configured to detect a first voltage at the first channel terminal 28 with respect to a voltage reference (e.g., GND), detect a second voltage at the second channel terminal with respect to the voltage reference, and generate the first boost current based on the first and second voltages. For example, the buffered voltages (e.g, output from the first and second buffers) may be level shifted to between 0 and 5V (e.g., via a voltage divider) to make the respective comparison to the voltage reference.

Each of the first and second buffers 72, 74 may be at least one of unitary gain buffer (UGB), a 2-transistor buffer, a voltage follower, and a cascade complementary source follower. Preferably, the output of the first and second buffers 72, 74 acts as a current source and/or sink.

In an example, the first buffer voltage is equal to the first voltage, and the second buffer voltage is equal to the second voltage. Thus, the voltage across the resistive element 76 is equal to the voltage across the controllable switch 22.

The first compensation circuit 24 may further comprise a first current mirror arrangement 78 configured to generate the first boost current based on the current flowing through the resistive element 76. The first current mirror may be provided such that the first boost current is a multiple of the current flowing through the resistive element 76. Thus, the first boost current may be proportional to the voltage difference across the controllable switch 22.

In an example, the resistive element 76 is a resistor. In alternative examples, it may be a depletion mode FET (e.g., JFET), or any resistive component. The value of the resistive element 76 may be predetermined to produce a current proportional to the switch threshold.

Figure 5 shows that the second boost current of the second compensation circuit 56 and the current associated with the switch control signal 32 of the switch current circuit 54 may be generated by secondary transistors of a current mirror arrangement. The primary transistor 71 of the current mirror arrangement is shown coupled to a current source 73. Each secondary transistor of the current mirror arrangement of the second compensation circuit 56 and of the switch current circuit 54 may be different, such that the amplitude of the second boost current and the current associated with the switch control signal 32 are also different.

As shown in Figure 5, the controllable switch 22 may comprise a first Field Effect Transistor (FET) device 21 and second FET device 23. In an example, a source terminal of the first FET 21 is coupled to a source terminal of the second FET 23. The control terminal of the controllable switch 22 comprises a gate terminal of the first FET device 21 and a gate terminal of the second FET device 23. The first channel terminal 28 comprises a drain terminal of the first FET device 21. The second channel terminal 30 comprises a drain terminal of the second FET device 23. Figure 5 also shows an optional biasing circuit 70 for biasing the source terminals of the first and second FET devices 21, 23.

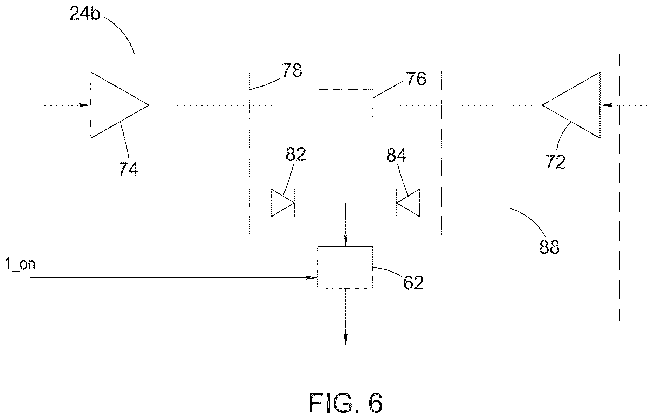

Figure 6 shows a first compensation circuit 24b. The first compensation circuit 24b of Figure 6 shows all of the features of the first compensation circuit 24 of Figure 5, in addition to certain optional features. The same reference numerals are used to denote the same/corresponding features in relation to Figure 5 and will not be described in detail again below. The first compensation circuit 24b is an alternative circuit to the first compensation circuit 24 shown in Figure 5. The first buffer 72 is configured to be couplable to the first channel terminal 28 and receive the corresponding voltage. The second buffer 74 is configured to be couplable to the second channel terminal 30 and receive the corresponding voltage.

The solid state switch device may be a bi-directional solid state switch comprising the first compensation circuit 24b of Figure 6. The first current mirror arrangement 78 is configured to generate the first boost current if a voltage at the first channel terminal 28 (i.e., input into the first buffer 72) is less than the voltage at the second channel terminal 30 (i.e., input into the second buffer 74). The first compensation circuit 24b further comprises a second current mirror arrangement 88 configured to generate the first boost current if a voltage at the second channel terminal 30 is greater than the voltage at the first channel terminal 28 of the controllable switch 22. First and second diodes 82, 84 are shown to prevent the first boost current (generated via one current mirror arrangement 78, 88) from flowing into the other current mirror arrangement 88, 78, and instead into the control switch 62.

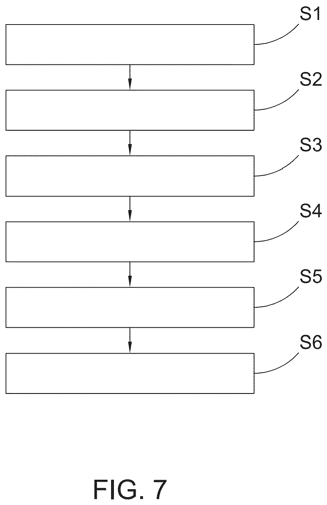

With reference to Figures 2, 4, 5, 6, the solid state switch device 52, 52a may be operated in accordance with a method for charging a switch capacitance at a control terminal 26 of a controllable switch 22 as shown in Figure 7.

The method, as shown in Figure 7, to charge a switch capacitance at a control terminal 26 of a controllable switch 22 may comprise the following steps:

| | |
|---|---|
| S1: | providing a switch control signal 32 which is configured to switch the controllable switch 22 from the off-state to the on-state. |
| S2: | determining a voltage difference between the first channel terminal 28 of the controllable switch 22 and the second channel terminal 30 of the controllable switch 22. |
| S3: | generating the first boost current based on to the voltage difference. |
| S4: | generating the second boost current of fixed amplitude. |
| S5: | applying the first boost current to the control terminal to charge a switch capacitance of the controllable switch 22. The first boost current may be applied during a transition of the controllable switch 22 from the off-state to the low-resistance on-state. |
| S6: | applying the second boost current to the control terminal 26 to charge a switch capacitance of the controllable switch 22, when the voltage difference between the first channel terminal 28 and the second channel terminal 30 is less than or equal to a difference threshold voltage. The second boost current may be applied at the same time (i.e., *t*₁) as the first boost current, and may be applied for longer than the first boost current (e.g., as shown in Figure 3). |

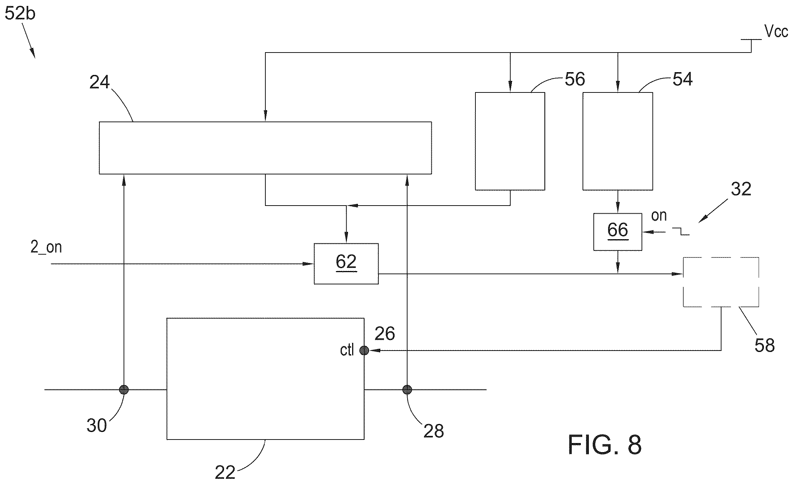

The solid state switch device 52b of Figure 8 shows certain features of the solid state switch device 52 of Figure 4, in addition to certain optional features. The same reference numerals are used to denote the same/corresponding features in relation to Figure 4 and will not be described in detail again below.

In the example of Figure 8, the control switch 62 may be arranged to couple the first compensation circuit 24 and the second compensation circuit 56 to the control terminal 26. Thus, the first control switch 62 may be configured to selectively apply the first and second boost currents. The first control switch 62 may be configured to apply the first and second boost currents during a transition of the controllable switch 22 from the off-state to the low-resistance on-state. During the low-resistance on-state of the controllable switch 22, during normal operation, the first control switch 62 may be configured to not apply the first and second boost currents. Thus, the second control switch 64 of Figure 4 is optional.

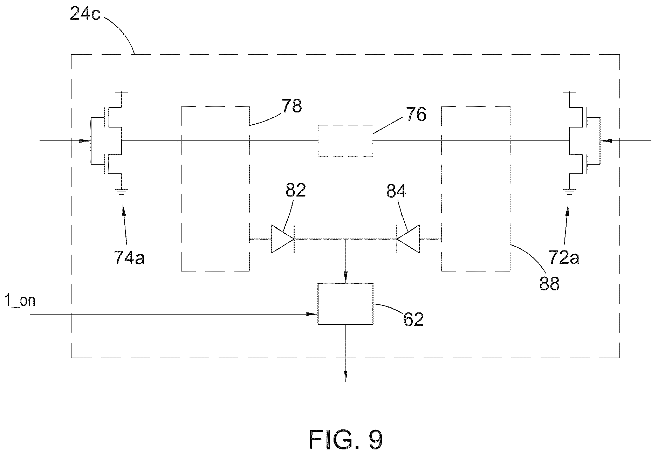

Figure 9 shows a first compensation circuit 24c. The first compensation circuit 24c of Figure 9 shows features of the first compensation circuit 24b of Figure 6, in addition to certain optional features. The same reference numerals are used to denote the same/corresponding features in relation to Figure 6 and will not be described in detail again below. The first compensation circuit 24c is an alternative circuit to the first compensation circuit 24b shown in Figure 6. The first buffer 72a may be a 2-transistor buffer. The second buffer 74 may be a 2-transistor buffer. The 2-transistor buffer 72a, 74a may be high voltage devices to accommodate for their input voltages. The 2-transistor buffer 72a, 74a are simple buffers which may reduce complexity and size, and may be selected if high voltages are expected on the first channel terminal 28 and/or second channel terminal 30.

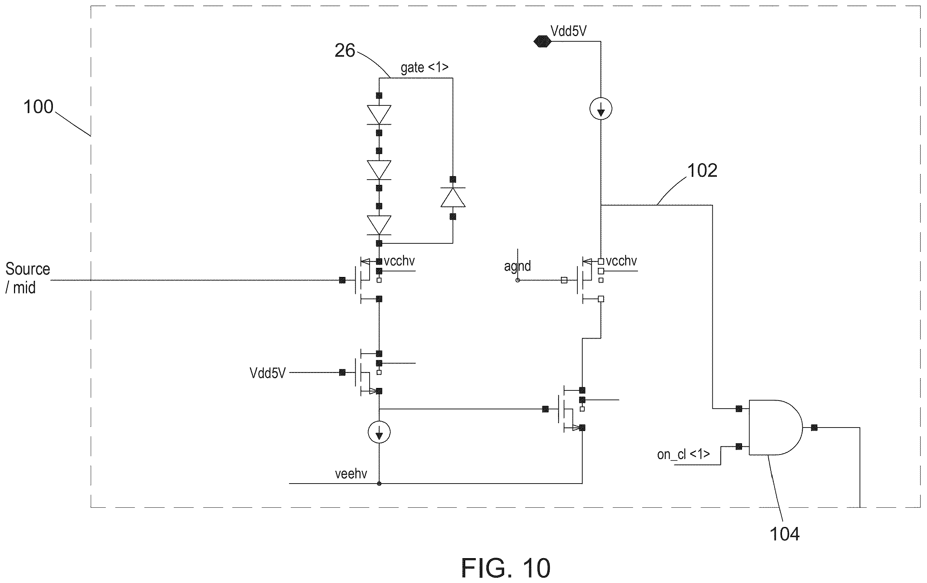

Figure 10 shows an example of an optional Vgs detect circuit 100 which receives the gate voltage and source voltage of the controllable switch 22. In an example, where the controllable switch comprises a first and second FET device 21, 23, then the circuit may receive the gate voltage of the first and second FET devices 21, 23, and the midpoint voltage (e.g., the source voltage) between the first and second FET devices 21, 23.

Figure 10 shows the optional Vgs detect circuit 100 which may be combinable with any example of the solid state switch device 52 with a second compensation circuit 56. The Vgs detect circuit 100 is configured to monitor a control voltage (i.e., gate voltage) at the control terminal 26 of the controllable switch 22 with respect to a reference voltage. The solid state switch device 52 may be further configured to stop applying the second boost current in response to determining that the control voltage (Vgs) reaches a control threshold voltage. For example, the Vgs detect circuit 100 is configured to compare the gate-source voltage of the controllable switch to a control threshold voltage, and generate a digital output 102 which may be used to prevent the second boost current from being applied to the control terminal of the controllable switch 26. In an example, the solid state switch device comprises an AND-gate 104 to receive the digital output 102 and an "on" signal, and generates a control signal to disconnect the output of the second compensation circuit from the control terminal 26 of the controllable switch 22. For example, the AND-gate 104 may generate the control signal "2_on" in the example of Figures 4 and 8.

For example, if the controllable switch 22 is an n-type device, then the solid state switch device 52 may be further configured to stop applying the second boost current in response to determining that the control voltage (e.g., Vgs) exceeds (or is equal to) a control threshold voltage. In an alternative example, if the controllable switch 22 is an p-type device, then the solid state switch device 52 may be further configured to stop applying the second boost current in response to determining that the control voltage (e.g., Vgs) is less than (or is equal to) a control threshold voltage.

Advantageously, the solid state switch device 52, as in Figure 10, which monitors the control voltage (e.g., Vgs) may automatically apply the second boost current until the switch capacitance is full. Thus, the switch capacitance may be charged without knowledge of the size of the switch capacitance. In an alternative example, the second boost current and the time for which it is applied to the switch capacitance may be predetermined based on the final Vgs and the size of the switch capacitance.

### General

Each block of Figures 2, 4, and 6 is shown and defined for explanatory purposes only, it would be well understood that the algorithm or function which each block represents may be implemented in a plurality of other ways so long as the functionality as described is present. For example, the blocks of Figures 2, 4, and/or 6 may be combined and implemented as part of a circuit arrangement, on a single integrated circuit, processor, or computer, or implemented by a plurality of circuit arrangements, integrated circuits, processors, and/or computers.

In the example of Figure 4, the first control switch 62 is shown to be distinct from the first compensation circuit 24. In an alternative example, the first compensation circuit 24 may comprise the first control switch 62.

In the example of Figure 4, the second control switch 64 is shown to be distinct from the second compensation circuit 56. In an alternative example, the second compensation circuit 56 may comprise the second control switch 64.

In the example of Figure 4, the third control switch 66 is shown to be distinct from the switch current circuit 56. In an alternative example, the switch current circuit 56 may comprise the third control switch 66.

In an example, the controllable switch 22 may comprise a FET. The first channel terminal 28 may comprise a drain terminal of the FET. The switch capacitance of the controllable switch 22 may comprise a parasitic gate-source capacitor (Cgs) of the FET.

In an example, the on-state of the controllable switch 22 may comprise a high-resistance on-state defined by the channel resistance between the first and second channel terminals of the controllable switch being greater than a predetermined first resistance threshold. The on-state may further comprise a low-resistance on-state defined by the channel resistance between the first and second channel terminals of the controllable switch being less than a predetermined second resistance. Optionally, the predetermined first resistance threshold is the second resistance threshold, or alternatively, the predetermined first resistance is greater than the predetermined second resistance threshold. In an example, the first boost current (and optionally the second boost current) is applied during a transition of the controllable switch from the off-state to the low-resistance on-state.

In an example, the on-state of the controllable switch 22 may comprise a high-resistance on-state defined by the control voltage of the controllable switch being greater than a predetermined voltage threshold (*Vₜ*) of the controllable switch and less than or equal to a target threshold voltage level. The on-state may further comprise a low-resistance on-state defined by the control voltage of the controllable switch being greater than the target threshold voltage level. Optionally, the target threshold voltage level is greater than the predetermined voltage threshold (*Vₜ*).

As shown in Figure 3, the first boost current is based on (and has a dynamic relationship to) the voltage difference between the first channel terminal 28 and the second channel terminal 30. As shown in Figure 3, between times *t*₂ and *t*₃ the voltage difference between the first channel terminal 28 and the second channel terminal 30 reduces, and the first boost current dynamically changes. In an alternative example, the initial voltage difference between the first and second channel terminals 28, 30 is determined at time *t*₁ (e.g., at, or in response to, the activation of the switch control signal 32 which is configured to switch the controllable switch 22 from the off-state to the on-state). The initial voltage difference may be proportional to the switch capacitance required to be charged. Thus, the solid state switch device may be configured to determine a fixed amplitude, and/or a time period to apply the first boost current. The first boost current is of the fixed amplitude and may be applied for the time period. The fixed amplitude, and/or the time period may be based on the voltage difference between the first channel terminal and the second channel terminal at a time prior to application of the first boost current. In an example, the time period may be predetermined to be a fixed time period. In an example, the solid state switch device may be further configured to stop applying the first boost current in response to determining that the voltage difference between the first and second channel terminals reaches or is less than the difference threshold voltage (e.g., a circuit similar to the optional Vgs detect circuit 100 of Figure 10 may be used, which is tuned to the difference threshold voltage rather than the control threshold voltage). Thus, the time period may be variable.

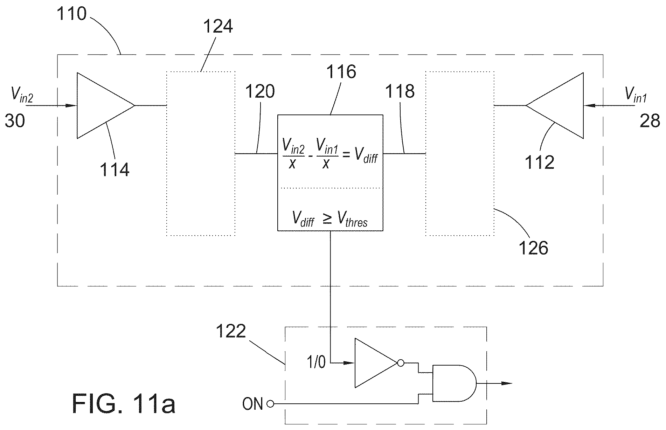

Figure 11a shows a voltage comparator circuit 110 arranged to generate a control signal configured to stop applying the first boost current in response to determining that the voltage difference between the first and second channel terminals 28, 30 reaches or is less than the difference threshold voltage.

The voltage comparator circuit 110 comprises a first buffer 112, a second buffer 114, and a difference and threshold circuit 116. The difference and threshold circuit 116 is arranged to determine the difference between the inputs 118, 120, and then compare the difference to the difference threshold voltage to generate a binary output. The binary output may be used to stop applying the first boost current in response to determining that the voltage difference between the first and second channel terminals 28, 30 reaches or is less than the difference threshold voltage, for example, via logic circuit 122. Optionally, as shown in Figure 11a, the voltage comparator circuit 110 further comprises a first and second level shifting circuits 124, 126 to reduce the voltages generated by the buffers 112, 114, to the low voltage (5V) domain. Advantageously, this enables the components of the difference and threshold circuit 116 to be low voltage (5V) components.

In an alternative example, without the first and second level shifting circuits 124, 126, the inputs 118, 120 to the difference and threshold circuit 116 may be substantially equal to the first voltage at the first channel terminal 28, and the second voltage at the second channel terminal 30, respectively.

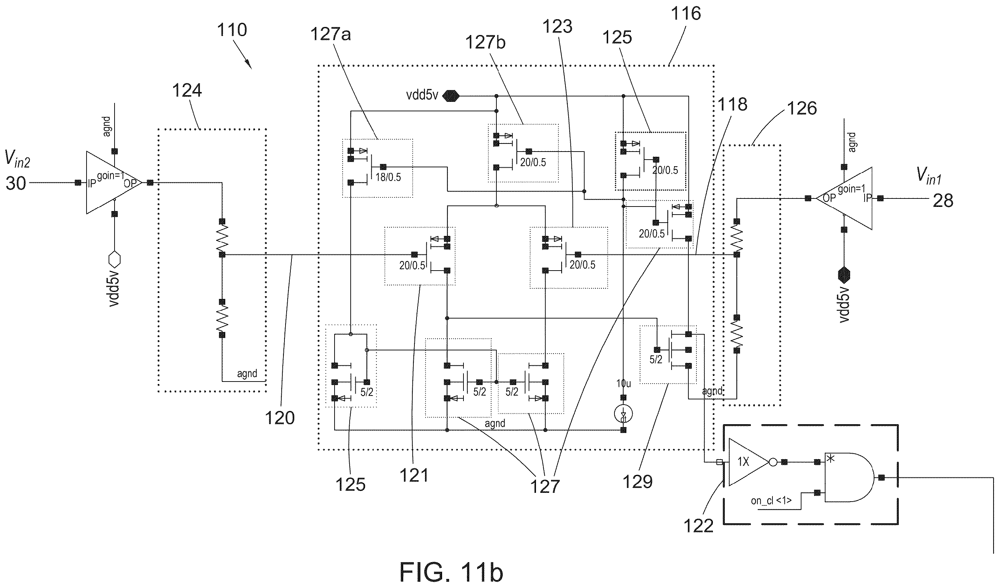

Figure 11b shows an example of the voltage comparator circuit 110 of Figure 11a. The voltage comparator circuit 110 of Figure 11b shows all of the features of the voltage comparator circuit 110 of Figure 11a, in addition to certain optional features. The same reference numerals are used to denote the same/corresponding features in relation to Figure 11a and will not be described in detail again below.

The example of Figure 11b shows the first and second level shifting circuits 124, 126 implemented as voltage divider circuits. An example of the difference and threshold circuit 116, is also shown in Figure 11b. The difference and threshold circuit 116 shown in Figure 11b is unidirectional such that it is configured to determined the voltage difference if the second voltage at the second channel terminal 30 is less than the first voltage at the first channel terminal 28. Scaling (also called sizing) of the transistors of the difference and threshold circuit 116 may be tuned to set the difference threshold voltage appropriately. In an example, the difference threshold voltage is determined such that the control signal is configured to stop applying the first boost current as the voltage difference between the first and second channel terminals 28, 30 reaches or is less than 5V, 1V, 0.5V, substantially zero volts, or 0V.

In the example of Figure 11b, the difference and threshold circuit 116 may comprise first transistor 121, second transistor 123, third transistor 129, current mirror transistors 125, and current source transistors 127, 127a, 127b. A first current source transistor 127a is slightly smaller and thus less current than second current source transistor 127b, so the gate of the third transistor 129 will be 'high' until the voltage difference between the voltage at the gate of the first transistor 121 and the voltage at the gate of the second transistor 123 is within the difference threshold voltage.

In an example, the controllable switch 22 is packaged with the compensation circuit. In an alternative example, the compensation circuit may be provided separately/independently from a controllable switch, such that the compensation circuit may be provided to many different controllable switches. Thus, the compensation circuit is configured to be coupled (or is couplable) to: a control terminal of a controllable switch; a first channel terminal of the controllable switch; and a second channel terminal of the controllable switch. The compensation circuit is further configured to generate a first boost current based on to a received voltage difference between the first channel terminal of the controllable switch and the second channel terminal of the controllable switch. The compensation circuit is further configured to output the first boost current for receipt by the control terminal of the controllable switch, to charge a switch capacitance of the controllable switch. Optionally, the compensation circuit may further be configured to generate the second boost current.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to."

The words "coupled" or "connected", as generally used herein, refer to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list.

It is to be understood that one or more features from one or more of the above-described embodiments may be combined with one or more features of one or more other ones of the above-described embodiments, so as to form further embodiments which are within the scope of the appended claims.

### Numbered Clauses

By way of non-limiting example, some aspects of the disclosure are set out in the following numbered clauses.
Clause 1. A solid state switch device, comprising:
   a controllable switch comprising a control terminal, a first channel terminal, and a second channel terminal, and arranged to be switched between an off-state and an on-state, wherein in the on-state the switch allows a current to flow between the first channel terminal and the second channel terminal; and
   a first compensation circuit configured to:
      generate a first boost current based on a voltage difference between the first channel terminal and the second channel terminal;
      apply the first boost current to the control terminal to charge a switch capacitance of the controllable switch.
Clause 2. The solid state switch device of clause 1, wherein the first compensation circuit is configured to apply the first boost current to the control terminal of the controllable switch during a transition of the controllable switch from the off-state to the on-state.
Clause 3. The solid state switch device of any of clauses 1 or 2, wherein the first compensation circuit is configured to apply the first boost current until the voltage difference between the first channel terminal and the second channel terminal reduces to or below a difference threshold voltage.
Clause 4. The solid state switch device of any preceding clause, wherein the first compensation circuit is configured to, during the application of the first boost current, adjust the first boost current proportionally with any changes to the voltage difference between the first channel terminal and the second channel terminal.
Clause 5. The solid state switch device of any preceding clause, wherein during application of the first boost current, the first boost current is of fixed amplitude, and wherein the first compensation circuit is configured to:
   apply the first boost current for a time period; and
   determine the fixed amplitude and time period based on the voltage difference between the first channel terminal and the second channel terminal at a time prior to application of the first boost current.
Clause 6. The solid state switch device of any preceding clause, wherein the solid state switch device further comprises an control switch arranged to couple the first compensation circuit to the control terminal, and wherein the control switch is configured to selectively apply the first boost current during a transition of the controllable switch from the off-state to the on-state.
Clause 7. The solid state switch device of any preceding clause, wherein the solid state switch device further comprises a second compensation circuit, wherein the second compensation circuit is configured to:
   generate a second boost current of predetermined fixed amplitude;
   apply the second boost current to the control terminal to charge a switch capacitance of the controllable switch during a transition of the controllable switch from the off-state to the on-state.
Clause 8. The solid state switch device of clause 7, wherein the second boost current is applied to charge a switch capacitance of the controllable switch during a period of time after the voltage difference between the first channel terminal and the second channel terminal is less than or equal to a difference threshold voltage.
Clause 9. The solid state switch device of any of clauses 7 or 8, wherein the fixed amplitude of the second boost current is less than the peak amplitude of the first boost current.
Clause 10. The solid state switch device of any of clauses 7 to 9, wherein the solid state switch device is configured to:
   monitor a control voltage at the control terminal with respect to a reference voltage; and
   stop applying the second boost current in response to determining that the control voltage reaches a control threshold voltage.
Clause 11. The solid state switch device of any preceding clause, wherein the first compensation circuit further comprises a first buffer, a second buffer, and a resistive component,
   wherein the first buffer is configured to: detect a first voltage at the first channel terminal and apply a first buffer voltage to a first terminal of the resistive element, wherein the first buffer voltage is proportional to the first voltage,
   wherein the second buffer configured to: detect a second voltage at the second channel terminal and apply a second buffer voltage to a second terminal of the resistive element, wherein the second buffer voltage is proportional to the second voltage.
Clause 12. The solid state switch device of clause 11, wherein the first compensation circuit comprises:
   a first current mirror arrangement configured to:
   generate the first boost current based on the current flowing through the resistive element.
Clause 13. The solid state switch device of clause 12, wherein the solid state switch device is a bi-directional solid state switch, wherein the first current mirror arrangement is configured to generate the first boost current if a voltage at the first channel terminal is greater than the voltage at the second channel terminal, and wherein the first compensation circuit further comprises:
   a second current mirror arrangement configured to generate the first boost current if a voltage at the second channel terminal is greater than the voltage at the first channel terminal.
Clause 14. The solid state switch device of any preceding clause, wherein the controllable switch comprises a first Field Effect Transistor, FET, wherein the control terminal comprises a gate terminal of the first FET.
Clause 15. The solid state switch device of clause 14, wherein the switch capacitance of the controllable switch is a parasitic gate-source capacitor (Cgs) of the first FET.
Clause 16. The solid state switch device of any preceding clause, wherein the controllable switch further comprises a second FET, and
   wherein a source terminal of the first FET is coupled to a source terminal of the second FET, and
   wherein the control terminal of the controllable switch further comprises a gate terminal of the second FET, and
   wherein the second channel terminal comprises a drain terminal of the second FET.
Clause 17. A method for charging a switch capacitance at a control terminal of a controllable switch, the method comprising:
   determining a voltage difference between a first channel terminal of a controllable switch and a second channel terminal of the controllable switch;
   generating a first boost current based on to the voltage difference; and applying the first boost current to the control terminal to charge a switch capacitance of the controllable switch.
Clause 18. The method of clause 17, wherein the first boost current is applied during a transition of the controllable switch from the off-state to the on-state.
Clause 19. The method of any of clauses 17 or 18, the method further comprising:
   generating a second boost current of fixed amplitude;
   applying the second boost current to the control terminal to charge a switch capacitance of the controllable switch when the voltage difference between the first channel terminal and the second channel terminal is less than or equal to a difference threshold voltage.
Clause 20. A compensation circuit configured to be coupled to:
   a control terminal of a controllable switch; a first channel terminal of the controllable switch; and a second channel terminal of the controllable switch, wherein the compensation circuit is further configured to:
   generate a first boost current based on a received voltage difference between the first channel terminal of the controllable switch and the second channel terminal of the controllable switch; and
   output the first boost current for receipt by the control terminal of the controllable switch.

## Claims

1. A solid state switch device, comprising:
a controllable switch comprising a control terminal, a first channel terminal, and a second channel terminal, and arranged to be switched between an off-state and an on-state, wherein in the on-state the controllable switch allows a current to flow between the first channel terminal and the second channel terminal; and
a first compensation circuit configured to:
generate a first boost current based on a voltage difference between the first channel terminal and the second channel terminal; and
apply the first boost current to the control terminal to charge a switch capacitance of the controllable switch.

2. The solid state switch device of claim 1, wherein the first compensation circuit is configured to apply the first boost current to the control terminal of the controllable switch during a transition of the controllable switch from the off-state to the on-state.

3. The solid state switch device of any of claims 1 or 2, wherein the first compensation circuit is configured to apply the first boost current until the voltage difference between the first channel terminal and the second channel terminal is less than or equal to a difference threshold voltage.

4. The solid state switch device of any preceding claim, wherein the first compensation circuit is configured to, during the application of the first boost current, adjust the first boost current proportionally with any changes to the voltage difference between the first channel terminal and the second channel terminal.

5. The solid state switch device of any preceding claim, wherein during application of the first boost current, the first boost current is of fixed amplitude, and wherein the first compensation circuit is configured to:
apply the first boost current for a time period; and
determine the fixed amplitude and the time period based on the voltage difference between the first channel terminal and the second channel terminal at a time prior to application of the first boost current.

6. The solid state switch device of any preceding claim, wherein the solid state switch device further comprises a control switch arranged to couple the first compensation circuit to the control terminal, and wherein the control switch is configured to selectively apply the first boost current during a transition of the controllable switch from the off-state to the on-state.

7. The solid state switch device of any preceding claim, wherein the solid state switch device further comprises a second compensation circuit, wherein the second compensation circuit is configured to:
generate a second boost current of a predetermined fixed amplitude; and
apply the second boost current to the control terminal to charge the switch capacitance of the controllable switch during a transition of the controllable switch from the off-state to the on-state.

8. The solid state switch device of claim 7, wherein the second boost current is applied to charge the switch capacitance of the controllable switch during a period of time after the voltage difference between the first channel terminal and the second channel terminal is less than or equal to a difference threshold voltage.

9. The solid state switch device of any of claims 7 or 8, wherein the predetermined fixed amplitude of the second boost current is less than a peak amplitude of the first boost current.

10. The solid state switch device of any of claims 7 to 9, wherein the solid state switch device is configured to:
monitor a control voltage at the control terminal with respect to a reference voltage; and
stop applying the second boost current in response to determining that the control voltage reaches a control threshold voltage.

11. The solid state switch device of any preceding claim, wherein the first compensation circuit further comprises a first buffer, a second buffer, and a resistive element,
wherein the first buffer is configured to detect a first voltage at the first channel terminal and apply a first buffer voltage to a first terminal of the resistive element, wherein the first buffer voltage is proportional to the first voltage,
wherein the second buffer configured to detect a second voltage at the second channel terminal and apply a second buffer voltage a second terminal of the resistive element, wherein the second buffer voltage is proportional to the second voltage.

12. The solid state switch device of claim 11, wherein the first compensation circuit comprises:
a first current mirror arrangement configured to generate the first boost current based on a current flowing through the resistive element.

13. The solid state switch device of claim 12, implemented as a bi-directional solid state switch, wherein the first current mirror arrangement is configured to generate the first boost current when the voltage at the first channel terminal is greater than the voltage at the second channel terminal, and wherein the first compensation circuit further comprises:
a second current mirror arrangement configured to generate the first boost current when the voltage at the second channel terminal is greater than the voltage at the first channel terminal.

14. A method for charging a switch capacitance at a control terminal of a controllable switch, the method comprising:
determining a voltage difference between a first channel terminal of the controllable switch and a second channel terminal of the controllable switch;
generating a first boost current based on to the voltage difference; and
applying the first boost current to the control terminal of the controllable switch to charge a switch capacitance of the controllable switch.

15. The method of claim 14, the method further comprising:
generating a second boost current of fixed amplitude; and
applying the second boost current to the control terminal to charge the switch capacitance of the controllable switch when the voltage difference between the first channel terminal and the second channel terminal is less than or equal to a difference threshold voltage.
